# EUROPÄISCHE PATENTSCHRIFT

(11) **EP 0 994 562 B1**
(45) Veröffentlichungstag und Bekanntmachung des Hinweises auf die Patenterteilung: **02.07.2008**
(21) Anmeldenummer: 99119879.7
(22) Anmeldetag: 07.10.1999
(51) Int. Cl.: H03G 3/34

(54) **Einrichtung zum Unterdrücken des Empfangs von fahrzeugemittierter Störstrahlung**
Device for suppression of radio interference caused by vehicles
Equipement permettand d'abaisser les interférences émises par un véhicule

(30) Priorität: 15.10.1998 DE 19847653
(43) Veröffentlichungstag der Anmeldung: 19.04.2000
(73) Patentinhaber: FUBA Automotive GmbH & Co. KG, 31162 Bad Salzdetfurth (DE)
(72) Erfinder: Lindenmeier, Heinz, 82152 Planegg (DE); Hopf, Jochen, 85540 Haar (DE); Reiter, Leopold, 82205 Gilching (DE)

(56) Entgegenhaltungen:
- EP-A- 0 792 020
- DE-A- 3 227 129
- US-A- 4 682 045
- US-A- 5 537 675
- PATENT ABSTRACTS OF JAPAN vol. 007, no. 099 (E-172), 27. April 1983 (1983-04-27) & JP 58 021928 A (FUJITSU TEN KK), 9. Februar 1983 (1983-02-09)

## Beschreibung

Die Erfindung betrifft eine Empfangsanlage für Kraftfahrzeuge 20 mit einer Einrichtung zur Unterdrückung des Empfangs von fahrzeugemittierter Störstrahlung 11.

Die durch die Fahrzeugaggregate emittierte Störstrahlung führt in der Bord-Empfangsanlage häufig zu einer beträchtlichen Minderung der Empfangsqualität. Insbesondere im Bereich des Lang-, Mittel- und Kurzwellenempfangs (AM-Bereich) ist der Hörrundfunkempfang häufig durch hörbare pulsartige Störungen stark beeinträchtigt. Häufig sind die durch die Zündanlage, oder/und durch digitale Komponenten hervorgerufene Störungen, deren hochfrequente Anteile über die Antenne 1 der Empfangsanlage 2 aufgenommen werden, derart intensiv, daß die Anbindung der Antenne 1 in der Nähe des Motors bzw. eines starken Störstrahlers nicht möglich ist. In der Praxis des Automobilbaus hat es sich gezeigt, daß die Unterdrückung der Störausstrahlung durch fahrzeugseitige Maßnahmen, wie durch besondere Ausgestaltung von Leitungsführungen bzw. der Einsatz von Entstörmittel häufig nicht durchführbar oder sehr kostspielig ist. Aus diesem Grunde werden Antennensysteme bei Fahrzeugen mit Frontmotor derzeit häufig im Heckbereich untergebracht, um mit Hilfe der größeren Entfernung von den Hauptstörquellen einen besseren Störabstand zu erzielen. Mit dem Trend zu Fensterscheibenantennen ergibt sich z.B. bei Cabrioletfahrzeugen mit Frontmotor die Forderung nach einer wirkungsvollen Unterdrückung von Empfangsstörungen im Bereich der Windschutzscheibe als einzig verfügbarem Fenster für die Gestaltung eines Fensterscheibenantennensystems. Fahrzeugstörungen sind jedoch häufig derart intensiv, daß sie auch bei entfernt von der Störquelle angebrachten Antennen noch hörbare Störungen hervorrufen, In der P 24 60 227.5 wird eine Lösung vorgeschlagen, Fahrzeugstörungen nach Betrag und Phase im HF-Bereich mit Hilfe eines Regelsystems aufzubereiten und in Überlagerung zum gestörten Empfangssignal der Empfangsanlage in der Weise zuzuführen, daß sich die Störanteile im Empfangssignal aufheben. Diese Methode ist jedoch kostenintensiv und auf die genaue Auswertung der in der Empfangsantenne wirksamen Störung angewiesen, was sich in vielen Fällen als unmöglich erweist.

Aufgabe der Erfindung ist es deshalb, für eine Empfangsanlage für Kraftfahrzeuge nach dem Oberbegriff des Hauptanspruchs eine wirkungsvolle und kostengünstige Einrichtung zu schaffen, um die Empfangsstörungen, welche mit der von Fahrzeugaggregaten emittierten Störstrahlung verbunden sind, insbesondere in den Frequenzbändern des amplitudenmodulierten Rundfunks, weitgehend unhörbar zu gestalten.

Diese Aufgabe wird erfindungsgemäß durch eine Empfangsanlage für Kraftfahrzeuge mit den Merkmalen des Anspruchs 1 gelöst.

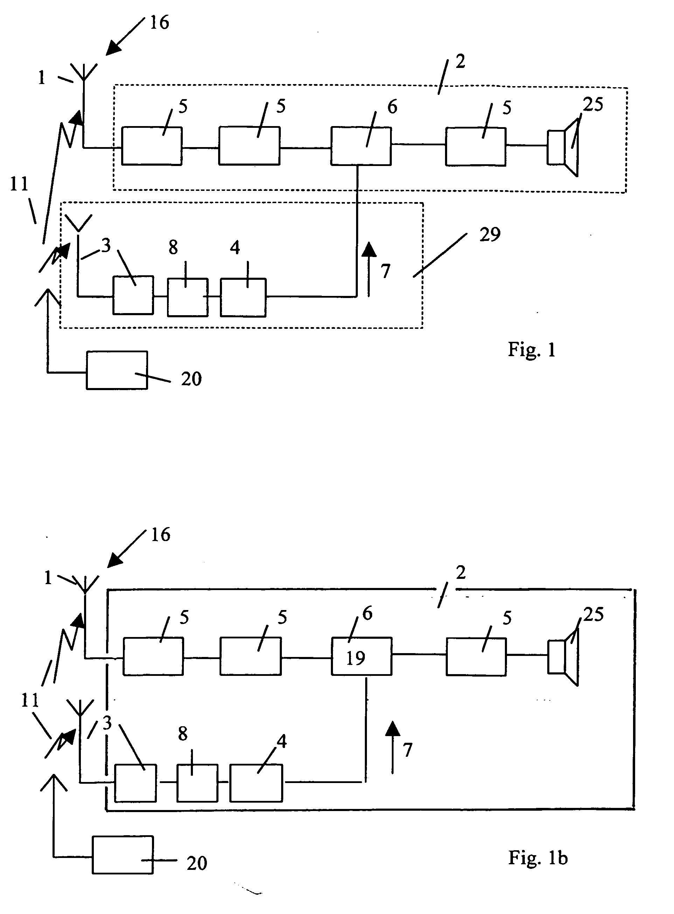

Erfindungsgemäße Ausführungsbeispiele sind in den angegebenen Zeichnungen dargestellt und werden im folgenden näher beschrieben. Im einzelnen zeigt:
Fig.1:
   a) Empfangsanlage nach der Erfindung mit Empfänger 2 mit Antenne 1 und einer Störsignal-Empfangseinrichtung 29, bestehend aus dem Koppelelement 3 mit *nach geschaltetem Bandpassfilter (8), welches mit seiner Mittenfrequenz (41) auf eine Festfrequenz abgestimmt ist* und einer Auswerteschaltung 4 zur Erzeugung eines Austastsignals 7 bei Aufnahme der vom Kraftfahrzeug 20 emittierten Störstrahlung 11. Das Austastsignal 7 bewirkt im steuerbaren Übertragungsglied 6 über die Zeitdauer des Auftretens der Störung durch die von der Antenne 1 empfangene Störstrahlung 11 eine Blockade der Übertragung, um die Störung vom Endgerät 25 fern zu halten.
   b) Empfangsanlage nach Fig.1, jedoch mit Gestaltung des Empfängers 2 mit der Auswerteschaltung 4 als funktionelle Einheit mit getrennten Eingängen für die Signale der Antenne 1 und die Signale des Koppelelements 3.

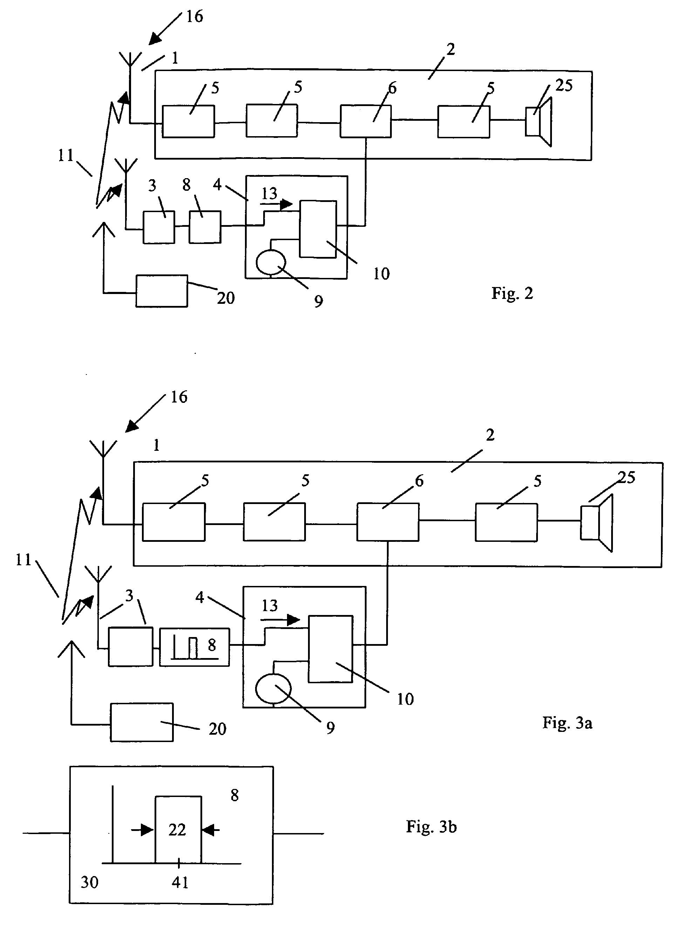

Fig.2: Empfangsanlage nach Fig.1, deren Auswerteschaltung 4 eine Logikschaltung 10 enthält, an deren Ausgang ein Austastsignal 7 entsteht, wenn der Störstrahlungspegel 13 den Referenzpegel 9 überschreitet.
Fig.3:
   a) Empfangsanlage nach Fig.2, in deren Störsignal-Empfangseinrichtung 29 mit einem Beispiel eines Bandpaßfilters 8 zur Begrenzung der Übertragungsbandbreite.
   b) Beispiel eines Bandpaßfilters 8, dessen Niederfrequenzteil 30 vorzugsweise auf die Mittenfrequenz des vor der Störstrahlung 11 zu schützenden Frequenzbereichs abgestimmt ist und dessen Bandbreite 22 geeignet gewählt ist.
Fig.4: Empfangsanlage nach der Erfindung mit einem als Überlagerungsempfänger mit Empfängermischer 23 und Oszillator 24 gestalteten Empfänger 2, deren Störsignal-Empfangseinrichtung 29 ebenfalls als Überlagerungsempfänger mit einem Störsignal-Mischer 12, einem Zwischenfrequenzfilter 14 und einer Demodulatorschaltung 17 gestaltet ist und deren Abstimmung durch Mischung des Signals im Störsignal-Mischer 12 mit demselben Oszillator 24 auf den gleichen Frequenzkanal wie des Empfängers 2 erfolgt.
Fig.5: Empfangsanlage nach Fig. 3a, wobei in der Kette der Übertragungsglieder 5 des Empfängers 2 ein Laufzeitglied 15 vor dem steuerbaren Übertragungsglied 6 im Empfänger 2 eingebracht ist.

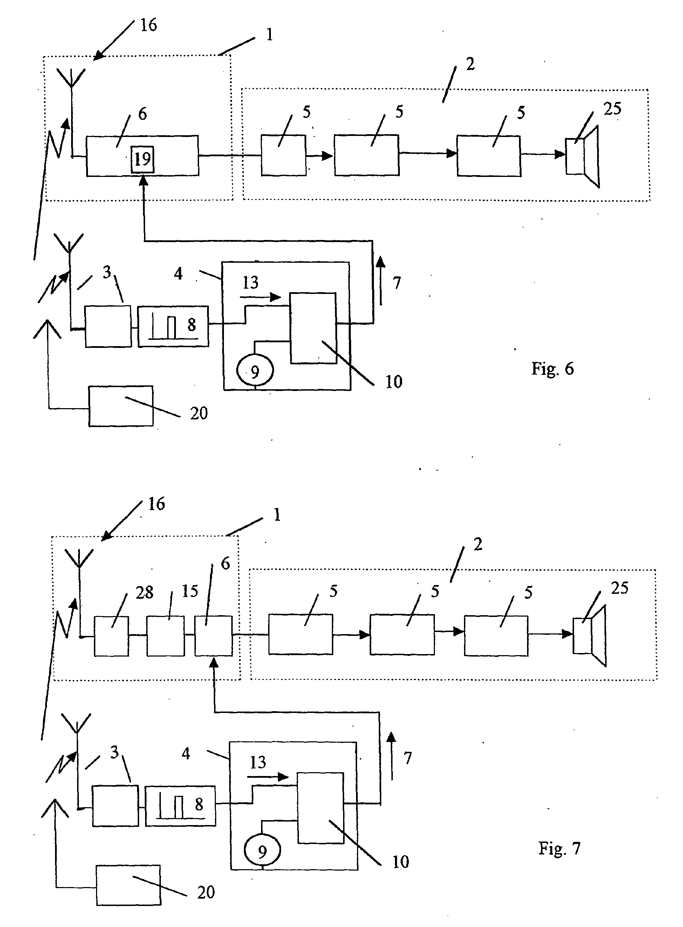

Fig.6: Empfangsanlage nach Fig.3a, wobei die Antenne 1 als steuerbares Übertragungsglied 6 mit einer darin enthaltenen Austastvorrichtung 19 vorhanden und dieser das Austastsignal 7 zugeführt ist.
Fig.7: Empfangsanlage nach Fig.6 mit einer aktiven Antenne mit Antennenverstärker 28, einem Laufzeitglied 15 mit nach geschaltetem steuerbarem Übertragungsglied 6.
Fig.8: Empfangsanlage mit einer Störsignal-Empfangseinrichtung 29 mit Bandpaßfilter 8, wobei das steuerbare Übertragungsglied mit der Austastvorrichtung 19 im Zwischenfrequenzteil des Empfängers 2 vorhanden und das Laufzeitglied 15 im Signalzweig der Störsignal-Empfangseinrichtung 29 enthalten ist.
Fig.9: Empfangsanlage mit einer als Überlagerungsempfänger gestalteten Störsignal-Empfangseinrichtung 29 gemäß Fig.4 mit einer Austastvorrichtung 19 im Bereich des Niederfrequenzteils 30 des Empfängers 2.
Fig.10: Empfangsanlage mit einem Koppelelement 3 als Störstrahlungsantenne 21 und einem Koppelleiter 32 in der Nähe der Antenne 1, welche als Fensterscheibenantenne ausgeführt ist.
   a) das Koppelelement 3 ist zur Aufnahme der in der Fensterrahmennähe befindlichen elektrischen Störstrahlungsfelder mit hoher Dichte der Störstrahlung 11 als elektrischer Koppelleiter 32 in einem geeigneten Abstand 24 im wesentlichen parallel zum metallischen Fensterrahmen des Kraftfahrzeugs 20 ausgeführt.
   b) das Koppelelement 3 ist zur Aufnahme der in der Fensterrahmennähe befindlichen magnetischen Störstrahlungsfelder mit hoher Dichte der Störstrahlung 11 als magnetische Koppelleiterschleife 32a in der Nähe des metallischen Fensterrahmens des Kraftfahrzeugs 20 ausgeführt.
   c) das Koppelelement 3 ist zur überlagerten Aufnahme der in der Fensterrahmennähe befindlichen elektrischen (E) und der magnetischen (H) Störstrahlungsfelder geeignet als kombinierte elektrisch und magnetisch wirkende Störstrahlungsantenne 21 mit vorzugsweise in der Nähe des metallischen Fensterrahmens des Kraftfahrzeugs 20 ausgeführt. Dies wird mit Hilfe einer Kapazität 40 und dem eingangsseitig kapazitiv hochohmigen dreipoligen steuerbaren Element 43 erreicht.

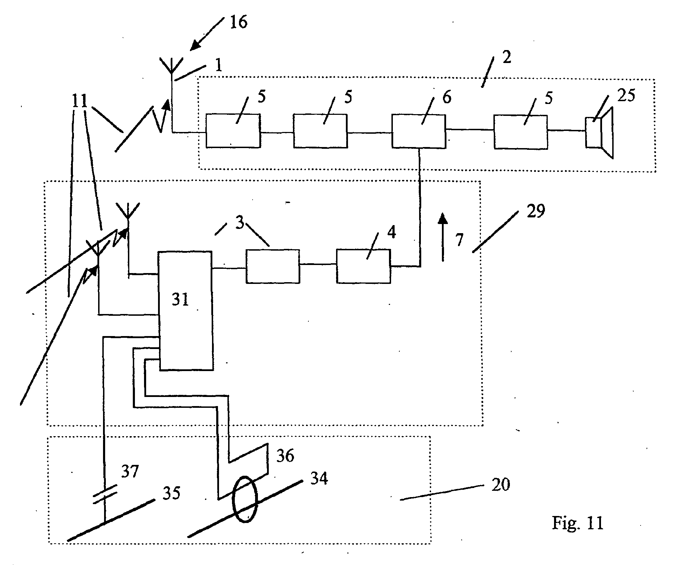

Fig.11: Empfangsanlage mit einer Störsignal-Empfangseinrichtung 29, der die Störstrahlung 11 über eine Matrixschaltung 31 gewichtet überlagert zugeführt ist. Die Einkopplung von Störsignalen als unmittelbare Auskopplung 36 aus einer den Störstrom führenden Leitung 34 mit Hilfe einer magnetischer Auskopplung oder als Auskopplung aus einer die Störspannung führenden Leitung 35 mit Hilfe einer elektrischen Auskopplung 37 des Kraftfahrzeugs 20.

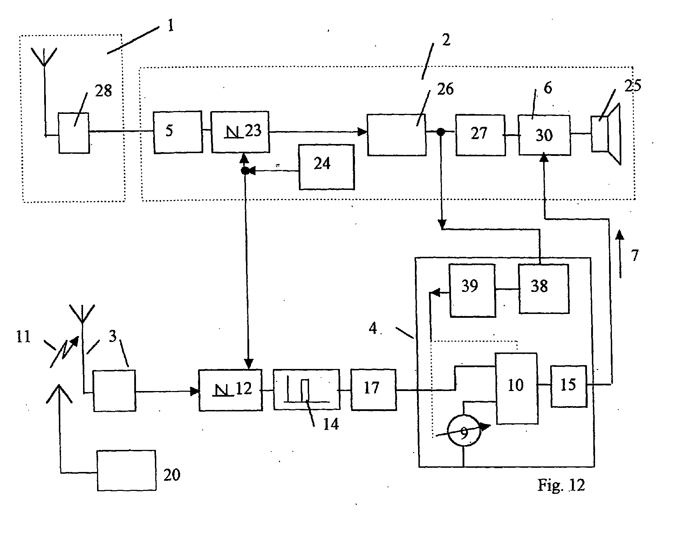

Fig.12: Empfangsanlage mit einem im Empfänger 2 befindlichen Pegelindikator 38 und einer Pegelbewertungsschaltung 39 zur Steuerung der Austastzeit und/oder der Austasttiefe durch Einstellung des Referenzpegels 9 und/oder der Logikschaltung 10.

Mit der vorliegenden Erfindung ist der Vorteil verbunden, daß die Ermittlung der Zeitintervalle, in denen das Empfangs-Nutzsignal 16 ausgetastet werden muß, damit die darin enthaltene, aufgrund der Störstrahlung 11 empfangene Störung nicht zum Endgerät 25 durchgeleitet wird, nicht im Empfangs-Nutzsignal 16 festgestellt wird. Die Erfindung zielt vielmehr darauf, daß mit Hilfe eines oder mehrerer Koppelelemente 3 die Störstrahlung 11 gesondert aufgegriffen wird und das dem Empfangs-Nutzsignal 16 entsprechende Signal möglichst klein ist. Dem Koppelelement 3 ist ein Bandpassfilter nachgeschaltet, dessen Bandbreite hinreichend groß gewählt ist, derart, *daß das zur Auswerteschaltung 4 gelangende Signal weitgehend repräsentativ für die im Empfangskanal des Empfängers 2 auftretenden Störungen ist.* Dadurch ist es möglich, die Austastzeit so kurz wie gerade nötig und die durch die Austastung der Empfangs-Nutzsignale 16 bewirkte Störung so klein wie möglich zu gestalten. In der Praxis zeigt sich, daß es nur sehr unvollkommen gelingt, mit schaltungstechnischen Maßnahmen, im Empfangs-Nutzsignal 16 befindliche Störungen im Empfänger 2 anzuzeigen, und mit Signalaustastung einen ungestörten Empfang zu erzielen, denn selbst bei großen Empfangs-Nutzsignal Störsignal-Verhältnissen ist z.B. der Rundfunkempfang häufig nennenswert gestört. Dies gilt insbesondere bei periodisch auftretenden Störungen im Empfangs-Nutzsignal 16, wie sie durch die elektrische Zündung bzw. durch die Pulse von Digitalsignalen insbesondere auch beim AM-Rundfunkempfang im Auto hervorgerufen werden. Die Erfindung zielt somit darauf ab, die Zeitintervalle des Auftretens von pulsartigen Störungen getrennt vom Empfangs-Nutzsignal 16 zu ermitteln und die Austastzeitpunkte und die Austastdauer gesondert mit einer Störsignal-Empfangseinrichtung 29 zu ermitteln. Dies wird unter anderem dadurch ermöglicht, daß das Koppelelement 3 zur Aufnahme der von den Fahrzeugaggregaten abgestrahlten, pulsförmigen, den Empfang störenden Störstrahlung 11 derart gestaltet und im Kraftfahrzeug 20 plaziert ist, daß sein Ausgangssignal in der Hauptsache die zu Empfangsstörungen führenden Pulse der Störstrahlung 11 enthält und der Anteil der Empfangs-Nutzsignale 16 möglichst gering ist.

*Aus Patent Abstracts of Japan Bd. 007, Nr. 099(E-172), vom 27. April 1983 (1983-04-27) und* JP 58021928A (Fujitsu Ten KK), vom 9. Februar 1983 *(1983-02-09) ist eine Einrichtung zur Austastung von Empfangs-Nutzsignalen zur Vermeidung von Störungen (noise blanker) bekannt. Die Störung wird dem noise blanker z.B. durch elektrische Ankopplung an die Zündkerzenströme zugeführt.*

*Diese Anordnung besitzt den Nachteil, dass die Störung breitbandig, d. h. ohne zwischengeschaltetes Bandfilter, welches mit seiner Mittenfrequenz (Mittenfrequenz 41) auf eine Festfrequenz abgestimmt ist, dem noise blanker zugeführt ist. Dadurch unterliegt das über die Ankopplung gewonnene, die Austastung auslösende Störsignal nicht der entsprechenden Bandspreizung, wie sie die Störsignale, die dem Nutzsignal überlagert sind, durch die Bandbegrenzung im Empfänger erfahren. Dadurch ist es nicht möglich, die Austastzeit so kurz wie gerade nötig und die durch die Austastung der Empfangs-Nutzsignale bewirkte Störung so kleinstmöglich zu gestalten. Eine ähnliche Anordnung ist aus der* DE 32 27 129 *bekannt. Auch diese Anordnung hat den Nachteil, dass dort kein entsprechendes Bandfilter vorhanden ist, dessen Durchlassfrequenzbereich auf die Empfangsfrequenz des Empfängers bezogen ist, und dass somit die Austastzeit nicht optimal eingestellt sein kann. Insbesondere ist es deshalb mit dieser Einrichtung nicht möglich, verhältnismäßig schwache Interferenzen festzustellen, wie etwa Schaltstörsignale im Spannungsregler.*

*Weiterhin ist aus der* US-A-5 537 675 *eine Schaltung zum Austasten von Störungen bekannt, deren wesentlicher Nachteil aber darin besteht, dass die Störungen der Austastschaltung nicht getrennt vom Nutzsignal über ein Koppelelement zugeführt werden. Diese werden vielmehr aus dem mit der Störung überlagerten Nutzsignal am Empfängereingang abgeleitet. Daraus resultiert eine wesentlich schlechtere Erkennung der Störungen.*

In Fig. 1a ist eine Empfangsanlage nach den Grundzügen der Erfindung mit Empfänger 2 mit Antenne 1 und einer Störsignal-Empfangseinrichtung 29 dargestellt. Diese besteht aus dem Koppelelement 3 *mit nach geschaltetem Bandfilter 8, welches mit seiner Mittenfrequenz auf eine Festfrequenz abgestimmt ist* und einer Auswerteschaltung 4 zur Erzeugung eines Austastsignals 7 bei Aufnahme der vom Kraftfahrzeug 20 emittierten Störstrahlung 11. Im einfachsten Fall ist im steuerbaren Übertragungsglied 6 eine Austastvorrichtung 19 enthalten, welche bei Zuführung des Austastsignals 7 bewirkt, daß über die Zeitdauer des Auftretens der Störung durch die von der Antenne 1 empfangene Störstrahlung 11 eine Blockade der Übertragung erfolgt, um die Störung vom Endgerät 25 fern zu halten. Die Austastung kann dabei als vollkommene Austastung über ein fest eingestelltes Zeitintervall erfolgen, wobei jedoch das Zeitintervall des Auftretens der Störung im Empfangs-Nutzsignal 16 und das in der Auswerteschaltung 4 erzeugte Austastsignal 7 möglichst deckungsgleich sein sollten. Ist die Austastzeit länger als das Auftreten der Störung im Empfangs-Nutzsignal 16, dann ist die durch die Austastung bewirkte unvermeidbare Störung unnötig groß. Umgekehrt wird bei zeitlich zu kurz gewähltem Austastsignal 7 die Störung im Empfangs-Nutzsignal 16 nicht vollkommen unwirksam. Die durch die Austastung selbst bewirkte Diskontinuität des Empfangssignals im Empfänger 2 kann durch an sich bekannte Austasttechniken wie "Sanfte Austastung" mit zeitlich verschliffenen Übergängen, angemessene "Austasttiefe", d.h. begrenzte Zurücknahme der Übertragungseigenschaft im steuerbares Übertragungsglied 6 bzw. durch "Sample and Hold"-Techniken, wobei der Momentanwert des Empfangs-Nutzsignals 16 während der Austastzeit auf dem letzten Wert gehalten wird etc., störungsarm gestaltet werden. Fig. 1b zeigt eine vorteilhafte Variante der Integration der Störsignal-Empfangseinrichtung 29 mit dem Empfänger 2 in einem Gehäuse mit getrennten Eingangsanschlüssen für die Antenne 1 und das Koppelelement 3.

In einer besonders einfachen Ausführungsform *einer entsprechenden Einrichtung zur Unterdrückung des Empfangs von fahrzeugemittierter Störstrahlung* wird die über das Koppelelement 3 aufgenommene Störstrahlung 11, breitbandig ausgewertet. Zur Auslösung des Austastvorgangs ist in der Auswerteschaltung 4 eine vergleichende Logikschaltung 10 mit zwei Eingängen vorhanden, deren einem Eingang der Störstrahlungspegel 13 zugeführt ist, welcher mit dem Referenzpegel 9 am anderen Eingang verglichen wird. Bei Überschreiten des Referenzpegels 9 durch den Störstrahlungspegel 13 wird am Ausgang der Logikschaltung 10 ein Austastsignal 7 generiert, welches den Austastvorgang im steuerbaren Übertragungsglied 6 bewirkt. Insbesondere bei zeitlichen Pulsformen, die nur relativ geringe Signalanteile im Frequenzbereich des Empfängers besitzen, ist die sich daraus ergebende Austastzeit *jedoch* zu wenig spezifisch für die tatsächlich notwendige Austastzeit, d.h. das Austastzeitintervall ist häufig zu lang oder/und nicht optimal zeitlich plaziert. *Deshalb wird, gemäß der vorliegenden Erfindung,* die Frequenzbandbreite in der Störsignal-Empfangseinrichtung 29 eingeengt. Dies geht aus den Figuren *1, 1b**,* *2*, 3a und 3b hervor. Hierbei ist dem Koppelelement 3 ein Bandpaßfilter 8 nachgeschaltet, *welches* mit seiner Mittenfrequenz auf eine Festfrequenz abgestimmt *ist,* und seine Bandbreite 22 ist hinreichend groß gewählt, so daß der von der Auswerteschaltung *4* angezeigte Störstrahlungspegel 13 weitgehend repräsentativ für die im Empfangskanal des Empfängers 2 auftretenden Störungen ist. Eine weitere Möglichkeit besteht darin, die Bandbreite 22 des Bandpaßfilters 8 etwa deckungsgleich mit dem Frequenzbereich zu gestalten, innerhalb dessen der Empfänger 2 abgestimmt werden kann.

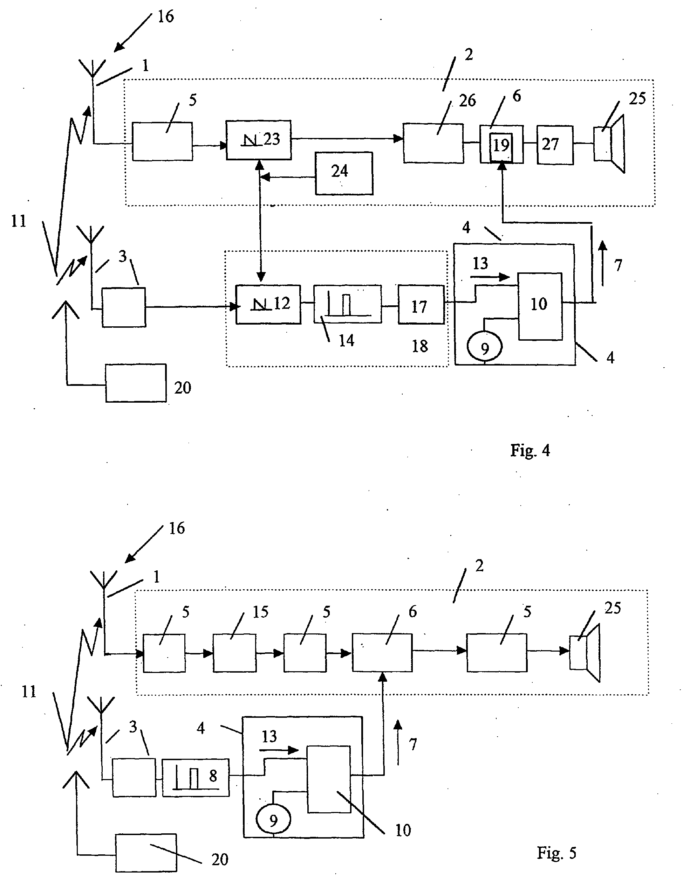

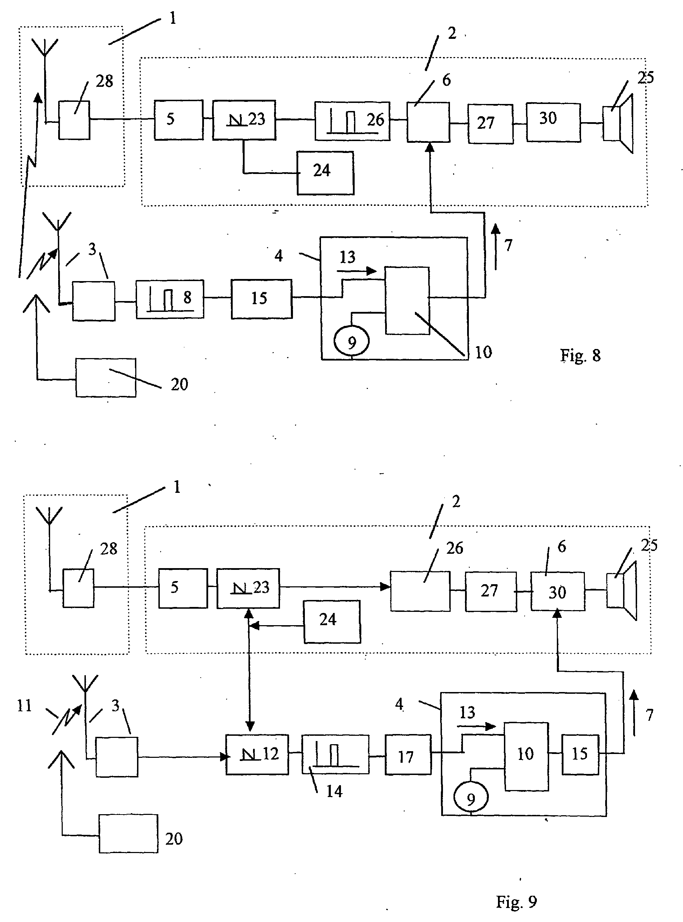

Um die Kongruenz der zeitlichen Plazierung des Austastintervalls mit dem Zeitpunkt des Auftretens der Störung im Empfangs-Nutzsignal 16 in einer beispielhaften Anordnung gemäß Fig. 5 zu verbessern, ist in Fig. 8 das Laufzeitglied 15 im Signalzweig der Störsignal-Empfangseinrichtung 29 eingefügt. Diese Retardierung des Signals kann, wie in Fig. 9 vorteilhaft auch mit Hilfe eines Laufzeitglieds 15 am Ausgang der Logikschaltung 10 eingebracht, erfolgen, wodurch das Austastsignal 7 um die notwendige Zeitdifferenz retardiert ist.

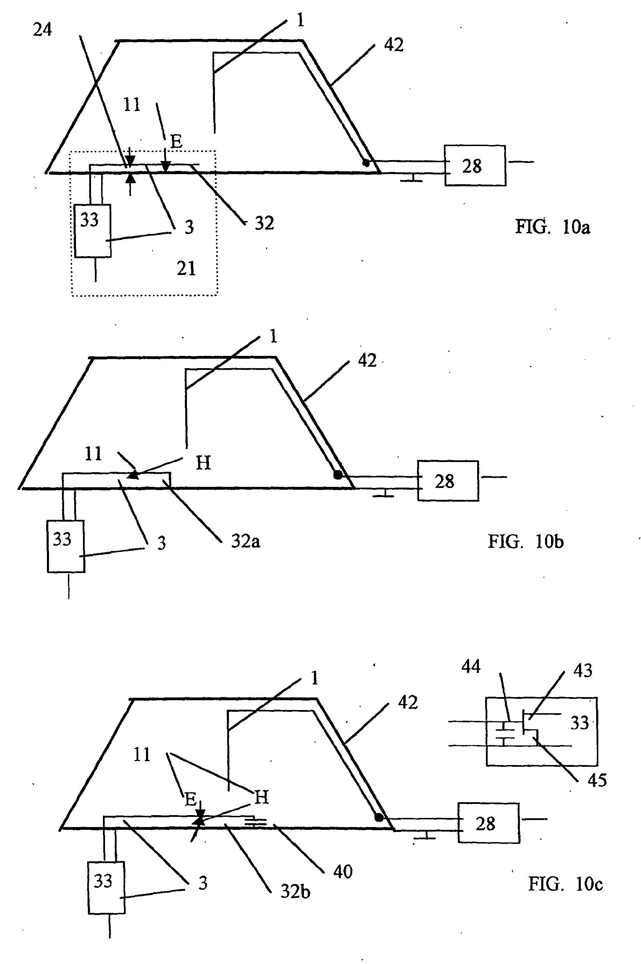

Um ein möglichst großes Verhältnis von Störstrahlungspegel 13 zu Empfangs-Nutzsignal 16 zu erzielen, ist es erfindungsgemäß vorteilhaft, das Koppelelement 3 als Störstrahlungsantenne 21 mit einem Koppelleiter 32 auszuführen und in der Nähe der Antenne 1 anzubringen. Dabei ist der Koppelleiter 32 jedoch derart zu gestalten, daß seine elektromagnetische Kopplung zur Karosserie des Fahrzeugs 20 wesentlich größer ist als die unvermeidbare Kopplung der Antenne 1 zur Karosserie des Fahrzeugs 20 und die damit verbundene Kopplung des Koppelelements 3 zum Freiraum wesentlich kleiner ist als die der Antenne 1, Damit sind die Aufnahmen der fahrzeuggebundenen Störstrahlungen 11 des Koppelelements 3 und der Antenne 1 einander ähnlich und die Austastung von Störungen im Empfangs-Nutzsignal 16 kann gezielt erfolgen. Ausführungsformen von Koppelelement 3 dieser Art sind beispielhaft in den Figuren 10a,b,c dargestellt. Das Koppelelement besteht jeweils aus dem Koppelleiter 32 mit einer Ankopplungsschaltung 33. In Fig. 10a ist der Koppelleiter 32 derart gestaltet, daß er die Störstrahlung 11 in Form der elektrischen Feldstärke E bevorzugt aufnimmt. In Fig.10b hingegen ist der Koppelleiter 32 als magnetische Schleife 32a zur Aufnahme der Störstrahlung 11 in Form der magnetischen Feldstärke H ausgeführt. Aufgrund der großen Konzentration der elektrischen und magnetischen Felder der Störstrahlung 11 in der unmittelbaren Umgebung des Fensterrahmens 42 ist die Anbringung des Koppelleiters 32 in der Nähe des Fensterrahmens 42 besonders wirkungsvoll. Die überlagerte Aufnahme von elektrischen und magnetischen Feldanteilen der Störstrahlung 11 erfolgt vorteilhaft mit Hilfe eines Koppelleiters 32, welcher, wie in Fig. 10c an beiden Enden z.B. kapazitiv belastet ist. Das elektronische Element 43 in der Ankopplungsschaltung 33 bildet mit seiner Eingangskapazität zwischen der Steuerelektrode 44 und der Quellelektrode 45 die kapazitive Last. Die Ausgangsspannung des elektronischen Elements 43 enthält sowohl durch magnetische als auch durch elektrische Feldanteile der Störstrahlung 11 bewirkte Anteile.

In Fig. 11 ist ein Koppelelement 3 zur Einkopplung von Störsignalen als unmittelbare induktive Kopplung an einen den Störstrom führenden elektrischen Leiter 34 gestaltet. Auf ähnliche Weise ist ein Koppelelement 3 als kapazitive Kopplung an einen die Störspannung führenden elektrischen Leiter 35 des Kraftfahrzeugs 20 dargestellt. Mit Hilfe einer Matrixschaltung werden in einer vorteilhaften Ausgestaltung der Erfindung die Signale mehrerer Koppelelemente 3 aus unterschiedlichen Störquellen linear und gewichtet überlagert. Eine solche Matrixschaltung kann z.B. als ein Widerstandsnetzwerk realisiert werden. Das Ausgangssignal der Matrixschaltung 31 ist der Auswerteschaltung 4 zugeführt und bei richtiger Gewichtung der einzelnen Störungsursachen können die Störungen dieser Ursachen im Empfangs-Nutzsignal 16 wirkungsvoll ausgetastet werden.

In Empfangssituationen, in denen ein hinreichend großer Pegel der Empfangs-Nutzsignale 16 vorliegt derart, daß die Störanteile infolge der Störstrahlung 11 sich nicht als Empfangsstörungen auswirken, ist es vorteilhaft, den Austastvorgang auszusetzen. Dadurch werden Reststörungen, welche mit der Austastung selbst verbunden sein können, vollkommen vermieden. Im Übergangsbereich des Pegels der Empfangs-Nutzsignale 16 zwischen dominanten pulsartigen Empfangsstörungen mit vollkommener Austastung und vernachlässigbaren pulsartigen Empfangsstörungen mit Aussetzung der Austastung zeigt es sich als vorteilhaft, die Austasttiefe pegelabhängig zu gestalten. Bei der in Fig. 12 dargestellten Empfangsanlage wird in einer vorteilhaften Weiterentwicklung der Erfindung der Signalpegel im Empfänger 2 einem Pegelindikator 38 zugeführt und in einer Pegelbewertungsschaltung 39 im Hinblick auf die Austastzeit und/oder die Austasttiefe bewertet und durch Einstellung des Referenzpegels 9 und/oder der Logikschaltung 10 eine geeignete Austastzeit und/oder die geeignete Austasttiefe eingestellt. Bei einer technisch besonders aufwandsarmen Realisierung wird in der Logikschaltung 10 das Pegelverhältnis der Empfangs-Nutzsignale 16 zum Störstrahlungspegel 13 festgestellt. Bei Unterschreiten eines Schwellwerts wird das steuerbare Übertragungsglied 6 im Niederfrequenzteil 30 durch Aktivieren mit Hilfe des Austastsignals 7 derart gesteuert, daß es während des Zeitintervalls des Austastens in Bezug auf das aktuelle Empfangs-Nutzsignal blockiert ist, an seinem Ausgang jedoch der letzte Wert vor Eintreten der Austastung vorliegt (sample and hold).
- 1: Antenne
- 2: Empfänger
- 3: Koppelelement
- 4: Auswerteschaltung
- 5: Übertragungsglieder
- 6: steuerbares Übertragungsglied
- 7: Austastsignal
- 8: Bandpaßfilter
- 9: Referenzpegel
- 10: logische Schaltung
- 11: Störstrahlung
- 12: Mischer
- 13: Störstrahlungspegel
- 14: Zwischenfrequenzfilter
- 15: Laufzeitglied
- 16: Empfangs-Nutzsignal
- 17: Demodulatorschaltung
- 18: Empfängerschaltung
- 19: Austastvorrichtung
- 20: Kraftfahrzeug
- 21: Störstrahlungsantenne
- 22: Bandbreite
- 23: Empfängermischer
- 24: Oszillator
- 25: Endgerät
- 26: Empfänger-ZF-Teil
- 27: Empfänger-Demodulator
- 28: Antennenverstärker
- 29: Störsignal-Empfangseinrichtung
- 30: Niederfrequenzteil
- 31: Matrixschaltung
- 32: Koppelleiter
- 32a: Koppelschleife
- 33: Ankopplungsschaltung
- 34: Störstrom führende Leitung
- 35: Störspannung führende Leitung
- 36: magnetische Auskopplung
- 37: elektrische Auskopplung
- 38: Pegelindikator
- 39: Pegelbewertungsschaltung
- 40: Kapazität
- 41: Mittenfrequenz
- 42: Fensterrahmen
- 43: kapazitiv hochohmiges dreipoliges steuerbares Element
- 44: Steuerelektrode
- 45: Quellelektrode

## Patentansprüche

1. Empfangsanlage für Kraftfahrzeuge (20) mit einer Antenne (1) und einem Empfänger (2) sowie einer Störsignal-Empfangseinrichtung (29), die aus einem Koppelelement (3) zur Aufnahme der von den Fahrzeugaggregaten abgestrahlten pulsförmigen, den Empfang störenden Störstrahlung (11) und einer Auswerteschaltung (4) mit Ausgangssignalen zur Anzeige der Störstrahlung (11) besteht, wobei
- der Empfänger (2) mit Antenne (1) eine Kette von Übertragungsgliedern (5) enthält mit einem in seinem Übertragungsverhalten zum Zwecke der Signalaustastung steuerbaren Übertragungsglied (6), dem die Ausgangssignale der Auswerteschaltung (4) in der Weise zugeführt sind, dass während der Dauer der pulsförmigen, den Empfang störenden Störstrahlung (11) die gestörten Empfangs-Nutzsignale (16) ausgetastet sind, und das Koppelelement (3) derart ausgebildet und im Kraftfahrzeug (20) platziert ist, dass sein Ausgangssignal in der Hauptsache die pulsförmige, den Empfang störende Störstrahlung (11) enthält und der Anteil der Empfangs-Nutzsignale (16) geringstmöglich ist, **gekennzeichnet durch** die folgenden Merkmale:
- dem Koppelelement (3) ist ein Bandpassfilter (8) nachgeschaltet, welches mit seiner Mittenfrequenz (41) auf eine Festfrequenz abgestimmt ist und in der Auswerteschaltung (4) zur Anzeige der Störstrahlung (11) sind ein Referenzpegel (9) gegeben und eine Logikschaltung (10) enthalten , **durch** welche das Überschreiten des Referenzpegels (9) **durch** den Störstrahlungspegel (13) **durch** ein Austastsignal (7) angezeigt ist und die Übertragung des Empfangssignals ausgetastet ist
- die Bandbreite (22) des Bandpassfilters (8) ist hinreichend groß gewählt, derart, dass der von der Auswerteschaltung (4) angezeigte Störstrahlungspegel (13) weitgehend repräsentativ ist für die im Empfangskanal des Empfängers (2) auftretenden Störungen.

2. Empfangsanlage nach Anspruch 1, **dadurch gekennzeichnet, dass** die Bandbreite (22) des Bandpassfilters (8) etwa deckungsgleich ist mit dem Frequenzbereich, innerhalb dessen der Empfänger (2) abgestimmt werden kann.

3. Empfangsanlage nach Anspruch 1, **dadurch gekennzeichnet, dass** der Durchlassbereich des Bandpassfilters (8) etwa deckungsgleich ist mit dem Empfangskanal, auf den der Empfänger (2) abgestimmt ist.

4. Empfangsanlage nach Anspruch 3, **dadurch gekennzeichnet, dass** der Empfänger (2) als Überlagerungsempfänger mit Empfängermischer (23), Oszillator (24), Empfänger-ZF-Teil (26), Empfänger-Demodulator (27) und Endgerät (25) ausgeführt ist, dass zur Abstimmung des Durchlassbereichs des Bandpassfilters auf den aktuellen Empfangskanal, auf den der Empfänger (2) abgestimmt ist, dem Koppelelement (3) eine Empfängerschaltung (18) nach dem Überlagerungsprinzip mit einem Mischer (12), einem Zwischenfrequenzfilter (14) und einer Demodulatorschaltung (17) nachgeschaltet und dem Mischer (12) das Oszillatorsignal des Empfängers (2) zugeführt ist und dass der Störstrahlungspegel (13) am Ausgang der Demodulatorschaltung (17) vorliegt.

5. Empfangsanlage nach Anspruch 1, **dadurch gekennzeichnet, dass** in der Kette der Übertragungsglieder (5) der Empfangsanlage, wegen des durch die Bandbegrenzung infolge des Bandpasses (8) retardierten logischen Signals am Ausgang der Logikschaltung (10) ein Laufzeitglied (15) vorgesehen ist, das zum Ausgleich von Laufzeitunterschieden in Richtung des Empfangssignalflusses vor dem steuerbaren Übertragungsglied (6) im Empfänger (2) bzw. in der Störsignal-Empfangseinrichtung (29) dient, so dass sichergestellt ist, dass der Zeitbereich des Austastens weitgehend kongruent ist mit dem Zeitbereich des Auftretens der Störung im Empfangssignal.

6. Empfangsanlage nach Anspruch 1, **dadurch gekennzeichnet, dass** die Antenne (1) als steuerbares Übertragungsglied (6) gestaltet ist, das mit einer Austastvorrichtung (19) versehen ist, der das Austastsignal (7) zugeführt ist.

7. Empfangsanlage nach Anspruch 6, **dadurch gekennzeichnet, dass** die Antenne (1) als aktive Antenne mit Antennenverstärker (28) ausgebildet ist und dass die Austastung durch Austastung der inneren Verstärkung der aktiven Antenne gegeben ist.

8. Empfangsanlage nach Anspruch 1, **dadurch gekennzeichnet, dass** zum Zwecke der Vermeidung eines großen Laufzeitunterschieds das steuerbare Übertragungsglied (6) mit der Austastvorrichtung (19) im Bereich der Zwischenfrequenz des Empfängers (2) und das Laufzeitglied (15) im Signalzweig der Störsignal-Empfangseinrichtung (29) angeordnet ist.

9. Empfangsanlage nach Anspruch 8, **dadurch gekennzeichnet, dass** das Laufzeitglied (15) am Ausgang der Logikschaltung (10) angeordnet und das Austastsignal (7) durch das Laufzeitglied um die notwendige Zeitdifferenz retardiert ist.

10. Empfangsanlage nach Anspruch 5, **dadurch gekennzeichnet, dass** zum Zwecke der Vermeidung eines großen Laufzeitunterschieds die Austastvorrichtung (19) im Bereich des Basisfrequenzbereichs (Niederfrequenzbereich) des Empfängers (2) vorgesehen ist.

11. Empfangsanlage nach Anspruch 1, **dadurch gekennzeichnet, dass** das Koppelelement (3) als Störstrahlungsantenne (21) mit einem Koppelleiter (32) ausgeführt und in der Nähe der Antenne (1) angebracht ist und dass der Koppelleiter (32) derart gestaltet ist, dass seine elektromagnetische Kopplung zur Karosserie des Fahrzeugs (20) und damit die Aufnahme der fahrzeuggebundenen Störstrahlung (11) wesentlich größer ist als die Kopplung der Antenne (1) zur Karosserie des Fahrzeugs (20) und dass die Kopplung des Koppelelements (3) zum Freiraum und die daraus resultierende Aufnahme von Empfangs-Nutzsignalen (16) durch das Koppelelement (3) wesentlich kleiner ist als die der Antenne (1).

12. Empfangsanlage nach Anspruch 11, **dadurch gekennzeichnet, dass** die Antenne (1) als Fensterscheibenantenne ausgeführt und das Koppelelement (3) zur Aufnahme der in der Fensterrahmennähe befindlichen elektrischen Störstrahlungsfelder mit hoher Dichte der Störstrahlung (11) als elektrisch wirkende Störstrahlungsantenne (21), vorzugsweise als elektrischer Koppelleiter (32), ausgebildet ist, der mit einem geeigneten Abstand (24) im wesentlichen parallel zum metallischen Fensterrahmen (42) des Kraftfahrzeugs (20) verläuft.

13. Empfangsanlage nach Anspruch 11, **dadurch gekennzeichnet, dass** der Abstand (24) derart gewählt ist, dass das Verhältnis der aus dem Störstrahlungspegel (13) und dem Empfangsnutzsignal (16) resultierenden Pegel am Ausgang des Koppelelements (3) maximal ist.

14. Empfangsanlage nach Anspruch 11, **dadurch gekennzeichnet, dass** die Antenne (1) als Fensterscheibenantenne und das Koppelelement (3) als magnetisch wirkende Störstrahlungsantenne (21), vorzugsweise als magnetische Koppelleiterschleife (32a) in der Nähe des metallischen Fensterrahmens (42) des Kraftfahrzeugs (20) ausgeführt ist.

15. Empfangsanlage nach Anspruch 11, **dadurch gekennzeichnet, dass** das Koppelelement (3) zur Aufnahme der in der Fensterrahmennähe befindlichen elektrischen und magnetischen Störstrahlungsfelder in geeigneter Weise als kombinierte elektrisch und magnetisch wirkende Störstrahlungsantenne (21) ausgeführt ist, die vorzugsweise in der Nähe des metallischen Fensterrahmens (42) des Kraftfahrzeugs (20) angeordnet ist.

16. Empfangsanlage nach Anspruch 15, **dadurch gekennzeichnet, dass** die Störstrahlungsantenne (21) im wesentlichen aus einem in geringem Abstand parallel zum metallischen Fensterrahmen (42) geführten, lang gestreckten Koppelleiter (32) besteht, der an einem Ende mit Hilfe einer Kapazität (40) mit dem diesem Ende benachbarten Fensterrahmen (42) verbunden und am anderen Ende an die Steuerelektrode (44) eines eingangsseitig hochohmigen dreipoligen steuerbaren Elements (43) angeschlossen ist, dass die Quellelektrode (45) des Elements (43) mit dem benachbarten leitenden Fensterrahmen (42) hochfrequenzmäßig verbunden ist und dass die Abmessungen der **dadurch** gebildeten Schleife und die Kapazität (40) derart gewählt sind, dass der aus der Störstrahlung (11) resultierende Störstrahlungspegel (13) möglichst repräsentativ ist für die im Empfänger (2) Störungen verursachenden Empfangssignale.

17. Empfangsanlage nach Anspruch 1, **dadurch gekennzeichnet, dass** das Koppelelement (3) zur Einkopplung von Störsignalen als unmittelbare induktive Kopplung an einen den Störstrom führenden elektrischen Leiter (34) oder als kapazitive Kopplung an einen die Störspannung führenden elektrischen Leiter (35) des Kraftfahrzeugs (20) oder mit Überlagerung von induktiver und elektrischer Kopplung ausgebildet ist.

18. Empfangsanlage nach Anspruch 1, **dadurch gekennzeichnet, dass** mehrere Koppelelemente (3) zur Einkopplung von Störungen aus unterschiedlichen Störquellen vorhanden sind, dass die Störungen einer Matrixschaltung (31) zur gewichteten Überlagerung der von den einzelnen Störquellen ausgehenden Störstrahlungen (11) zugeführt sind und das Ausgangssignal der Matrixschaltung (31) der Auswerteschaltung (4) zugeführt ist.

19. Empfangsanlage nach Anspruch 1, **dadurch gekennzeichnet, dass** der Signalpegel im Empfänger (2) einem Pegelindikator (38) zugeführt und in einer Pegelbewertungsschaltung (39) im Hinblick auf die Austastzeit und/oder die Austasttiefe bewertet ist und dass durch Einstellung des Referenzpegels (9) und/oder der Logikschaltung (10) eine geeignete Austastzeit und/oder die geeignete Austasttiefe eingestellt ist.

## Claims

1. Reception equipment for motor vehicles (20) with an antenna (1) and a receiver (2) as well as an interference signal reception system (29) comprising a coupling element (3) for the capture of pulse-shaped interference radiation (11) which radiates from the vehicle assemblies and interferes with reception, and an evaluation circuit (4) with output signals for the display of the interference radiation (11), (**characterized by** the following features:) whereby
- the receiver (2) with antenna (1) contains a series of transmission elements (5) with a transmission element (6), the transmission characteristics of which can be controlled for the purposes of optimized signal utilization, to which the output signals of the evaluation circuit (4) are fed in a way that, for the duration of the pulse-shaped interference radiation (11) which interferes with reception, the disrupted useful signals received (16) are detected and the coupling element (3) is configured and placed in the vehicle (20) in such a way that its output signal essentially contains the pulse-shaped interference radiation (11) which interferes with reception and the share of the useful signals received (16) is as small as possible,
- a band-pass filter (8), the centre frequency (41) of which is set to a fixed frequency, is installed downstream of the coupling element (3), and the evaluation circuit (4) for the display of the interference radiation (11) includes a reference level (9) and a logic circuit (10), by means of which a detection signal (7) is displayed and the transmission of the signal received is detected when the interference radiation level (13) exceeds the reference level (9)
- the bandwidth (22) of the band-pass filter (8) is selected to be sufficiently large so as to ensure that the interference radiation level (13) displayed by the evaluation circuit (4) is largely representative of the interference to which the receive channel of the receiver (2) is subjected.

2. Reception equipment according to Claim 1, **characterized by** a bandwidth (22) of the band-pass filter (8) that essentially matches that of the frequency range over which the receiver (2) can be tuned.

3. Reception equipment according to Claim 1, **characterized by** a pass band of the band-pass filter (8) that essentially matches the receive channel to which the receiver (2) is tuned.

4. Reception equipment according to Claim 3, **characterized by** the fact that the receiver (2) is equipped as a superheterodyne receiver with a receiver mixer (23), oscillator (24), receiver IF component (26), receiver demodulator (27) and end device (25), and by the fact that, for the tuning of the pass band of the band-pass filter to the receive channel to which the receiver (2) is currently tuned, a reception circuit (18) according to the superheterodyne principle with a mixer (12), an intermediate filter (14) and a demodulator circuit (17) is installed downstream of the coupling element (3) and the oscillator signal of the receiver (2) is fed to the mixer (12), and by the fact that interference radiation level (13) is present at the output of the demodulator circuit (17).

5. Reception equipment according to Claim 1, **characterized by** the fact that in the series of transmission elements (5) of the reception equipment, as a result of the band limitation due to the delayed logic signal caused by the band-pass filter (8), a delay element (15) is provided at the output of the logic circuit (10), which serves to compensate for delay differences in the direction of flow of the signal received ahead of the controllable transmission element (6) in the receiver (2) and/or in the interference signal reception direction (29), thus ensuring that the range of time of the detection is largely congruent with the range of time of the occurrence of the noise in the signal received.

6. Reception equipment according to Claim 1, **characterized by** the fact that the antenna (1) is designed as a controllable transmission element (6), which is provided with a detection system (19) to which the detection signal (7) is fed.

7. Reception equipment according to Claim 6, **characterized by** the fact that the antenna (1) forms an active antenna with the antenna amplifier (28) and by the fact that detection is provided by detection of the internal amplification of the active antenna.

8. Reception equipment according to Claim 1, **characterized by** fact that, for purposes of avoiding a large delay differential, the controllable transmission element (6) is arranged with the detection system (19) in the range of the intermediate frequency of the receiver (2) and the delay element (15) in the signal branch is arranged in the interference signal reception direction (29).

9. Reception equipment according to Claim 8, **characterized by** the fact that the delay element (15) is arranged at the output of logic circuit (10) and the delay element retards the detection signal (7) by the necessary time differential.

10. Reception equipment according to Claim 5, **characterized by** the fact that, for purposes of avoiding a large delay differential, the detection system (19) is provided in the range of the basic frequency range (low frequency range) of the receiver (2).

11. Reception equipment according to Claim 1, **characterized by** the fact that the coupling element (3) is designed as an interference radiation antenna (21) with a coupling conductor (32) and is mounted near the antenna (1) and by the fact that the coupling conductor (32) is designed in a way that the electromagnetic coupling to the body of the vehicle (20), and thereby the capture of the vehicle-related interference radiation (11), are significantly greater than the coupling of the antenna (1) to the body of vehicle (20), and that the coupling of the coupling element (3) to the free space and the resulting capture of useful signals received (16) via the coupling element (3) is significantly smaller than that of antenna (1).

12. Reception equipment according to Claim 11, **characterized by** the fact that the antenna (1) is configured as a windowpane antenna and the coupling element (3) for the capture of the electrical interference radiation fields with high density to the interference radiation (11) is constructed as an electrically acting interference radiation antenna (21), preferably as an electrical coupling conductor (32), which runs at a suitable distance (24) essentially parallel to the metal window frame (42) of the vehicle (20).

13. Reception equipment according to Claim 11, **characterized by** the fact that the distance (24) is selected in a way that the ratio of the interference radiation level (13) to the level resulting from the useful signal received (16) is maximized at the output of the coupling element (3).

14. Reception equipment according to Claim 11, **characterized by** the fact that the antenna (1) is designed as a windowpane antenna and the coupling element (3) is designed as a magnetically acting interference radiation antenna (21), preferably as a magnetic coupling conductor loop (32a) in the vicinity of the metal window frame (42) of the vehicle (20).

15. Reception equipment according to Claim 11, **characterized by** the fact that the coupling element (3) for capturing the electrical and magnetic interference radiation fields in the vicinity of the window frame is configured in a suitable way as a combined electrically and the magnetically acting interference radiation antenna (21) that is arranged in the vicinity of the metal window frame (42) of the vehicle (20).

16. Reception equipment according to Claim 15, **characterized by** the fact that the interference radiation antenna (21) basically consists of a coupling conductor (32) routed parallel to, and at a small distance from the metallic window frame (42), connected at one end by means of a capacitance (40) to the neighbouring window frame (42) and connected at the other end to the control electrode (44) of a three-pole controllable element (43) with a high-ohm input, and by the fact that the source electrode (45) of the element (43) has a highfrequency connection with the neighbouring conducting window frame (42), and by the fact that the dimensions of the loops formed by this and the capacitance (40) are selected in a way that the interference radiation level (13) resulting from the interference radiation (11) is as representative as possible of the signals received that lead to noise in receiver (2).

17. Reception equipment according to Claim 1, **characterized by** the fact that the coupling element (3) for coupling the interference signals is configured as a directly inductive coupling to an electrical conductor (34) of the vehicle (20) leading to the interference current, or as a capacitive coupling to an electrical conductor (35) of the vehicle (20) leading to the interference voltage, or with superposition of inductive and electrical coupling.

18. Reception equipment according to Claim 1, **characterized by** the fact that there are multiple coupling elements (3) for the coupling of noise from different interference sources, and by the fact that the noise is fed into a matrix circuit (31) for the weighted superposition of the interference radiation (11) emitted from the separate noise sources, and by the fact that the output signal of matrix circuit (31) is fed to the evaluation circuit (4).

19. Reception equipment according to Claim 1, **characterized by** the fact that the signal level in the receiver (2) is fed into a level indicator (38) and evaluated relative to detection time and/or detection depth in a level evaluation circuit (39), and by the fact that adjusting the reference level (9) and/or the logic circuit (10) sets a suitable detection time and/or the suitable detection depth.

## Revendications

1. Installation de réception pour véhicules automobiles (20) avec antenne (1) et récepteur (2), ainsi qu'avec une installation de réception de signaux perturbateurs (29) composée d'un élément de couplage (3) pour la réception du rayonnement perturbateur émis sous forme d'impulsions par les agrégats du véhicule et entravant la réception (11) et un circuit d'évaluation (4) avec signaux de sortie pour l'affichage du rayonnement perturbateur (11), le récepteur (2) avec antenne (1) contenant une chaîne d'éléments de transmission (5) avec un élément de transmission (6) dont les caractéristiques de transmission sont contrôlables pour permettre la suppression des signaux et auquel les signaux de sortie du circuit d'évaluation (4) sont acheminés de sorte que, pendant la durée du rayonnement perturbateur entravant la réception qui est émis sous forme d'impulsions (11), les signaux de réception perturbés (16) sont supprimés et que l'élément de couplage (3) est conçu et positionné dans le véhicule (20) de sorte que son signal de sortie contient principalement le rayonnement perturbateur émis sous forme d'impulsions (11) et que la quote-part de signaux de réception (16) soit le plus faible possible.
- un filtre de passe-bande (8) dont la fréquence médium (41) est adaptée à une fréquence fixe, est installé derrière l'élément de couplage (3) et le circuit d'évaluation (4) pour l'affichage du rayonnement perturbateur (11) comprend un niveau de référence (9) et un circuit logique (10) assurant que le dépassement du niveau de référence (9) par le niveau du rayonnement perturbateur (13) est affiché par un signal de suppression (7) et que la transmission du signal de réception est supprimée.
- la largeur de bande (22) du filtre passe-bande (8) est suffisamment grande de sorte que le niveau de rayonnement perturbateur (13) affiché par le circuit d'évaluation (4) est assez représentatif des perturbations survenant dans le canal de réception du récepteur (2)

2. Installation de réception selon la revendication 1 **caractérisée par le fait que** la largeur de bande (22) du filtre passe-bande (8) est presque identique à la gamme de fréquences au sein de laquelle le récepteur (2) peut être accordé.

3. Installation de réception selon la revendication 1 **caractérisée par le fait que** la bande passante du filtre passe-bande (8) est presque identique au canal de réception auquel le récepteur (2) est accordé.

4. Installation de réception selon la revendication 3 **caractérisée par le fait que** le récepteur (2) est exécuté comme récepteur superhétérodyne avec mélangeur de réception (23), oscillateur (24), pièce FI du récepteur (26), démodulateur de récepteur (27) et appareil terminal (25) que, pour l'accord de la bande passante du filtre passe-bande sur le canal de réception actuel sur lequel le récepteur (2) est accordé, un circuit récepteur (18) est installé derrière l'élément de couplage (3) selon le principe de recouvrement avec un mélangeur (12), un filtre de fréquence intermédiaire (14) et un circuit de démodulateur (17) et que le signal d'oscillateur du récepteur (2) est transmis au mélangeur (12) et que le niveau de rayonnement perturbateur (13) est présent sur la sortie du circuit de démodulateur (17).

5. Installation de réception selon la revendication 1, **caractérisée par le fait que**, dans la chaîne des éléments de transmission (5) de l'installation de réception un élément de retard (15) est prévu sur la sortie du circuit logique (10) en raison du signal logique retardé par la limitation de la bande suite au filtre passe-bande (8), cet élément de retard servant à la compensation de différences du temps de propagation dans le sens du flux du signal de réception avant l'élément de transmission contrôlable (6) dans le récepteur (2) ou bien dans l'installation de réception des signaux perturbateurs (29) de sorte qu'il est assuré que la plage de temps de la suppression est presque complètement congrue avec la plage de temps de la survenance de la perturbation dans le signal de réception,

6. Installation de réception selon la revendication 1 **caractérisée par le fait que** l'antenne (1) est réalisée comme élément de transmission contrôlable (6) étant muni d'un dispositif de suppression (19) auquel le signal de suppression (7) est transmis.

7. Installation de réception selon la revendication 6 **caractérisée par le fait que** l'antenne (1) est réalisée comme antenne active avec amplificateur d'antenne (28) et que la suppression est assurée par la suppression de l'amplification interne de l'antenne active.

8. Installation de réception selon la revendication 1 **caractérisée par le fait que**, afin d'éviter une différence importante du temps de propagation, l'élément de transmission contrôlable (6) avec le dispositif de suppression (19) est positionné dans le domaine de la fréquence intermédiaire du récepteur (2) et que l'élément de retard (15) est positionné dans la branche de signal de l'installation de réception de signaux perturbateurs (29).

9. Installation de réception selon la revendication 8 **caractérisée par le fait que** l'élément de retard (15) est positionné sur la sortie du circuit logique (10) et que le signal de suppression (7) est retardé de la différence de temps nécessaire par l'élément de retard.

10. Installation de réception selon la revendication 5 **caractérisée par le fait que**, afin d'éviter une différence importante du temps de propagation, le dispositif de suppression (19) est prévu dans le domaine de la gamme de fréquences de base (basse fréquence) du récepteur (2).

11. Installation de réception selon la revendication 1 **caractérisée par le fait que** l'élément de couplage (3) est réalisé comme antenne pour rayonnements perturbateurs (21) avec conducteur de couplage (32) et est positionné à proximité de l'antenne (1) et que le conducteur de couplage (32) est conçu de sorte que son couplage électromagnétique avec la carrosserie du véhicule (20) et, par conséquent, la réception du rayonnement perturbateur lié au véhicule (11) est nettement plus important que le couplage de l'antenne (1) avec la carrosserie du véhicule (20) et que le couplage de l'élément de couplage (3) avec l'espace libre et la réception de signaux de réception (16) par l'élément de couplage (3) qui en résulte, sont nettement moins importants que ceux de l'antenne (1).

12. Installation de réception selon la revendication 11 **caractérisée par le fait que** l'antenne (1) est réalisée comme antenne intégrée dans la vitre et que l'élément de couplage (3) pour la réception des champs électroniques propageant un rayonnement perturbateur très dense (11) à proximité du cadre de la vitre, est réalisé comme antenne de rayonnement perturbateur à effet électrique (21) et de préférence comme conducteur électrique de couplage (32) qui, à une distance adéquate (24), est posé principalement parallèlement au cadre métallique de la vitre (42) du véhicule automobile (20).

13. Installation de réception selon la revendication 11 **caractérisée par le fait que** la distance (24) est choisie de sorte que le rapport entre les niveaux résultant du niveau du rayonnement perturbateur (13) et du signal de réception (16) est le plus grand possible sur la sortie de l'élément de couplage (3).

14. Installation de réception selon la revendication 11 **caractérisée par le fait que** l'antenne (1) est réalisée comme antenne intégrée dans la vitre et que l'élément de couplage (3) est réalisé comme antenne de rayonnement perturbateur à effet magnétique (21) étant de préférence posée sous forme d'un conducteur de couplage magnétique (32a) à proximité du cadre métallique de la vitre (42) du véhicule automobile (20).

15. Installation de réception selon la revendication 11 **caractérisée par le fait que** l'élément de couplage (3) pour la réception des champs électriques et magnétiques propageant un rayonnement perturbateur à proximité du cadre de la vitre est réalisé de manière adéquate comme antenne de rayonnement perturbateur combinée à effet électrique et magnétique (21) étant posée de préférence à proximité du cadre métallique de la vitre (42) du véhicule automobile (20).

16. Installation de réception selon la revendication 15 **caractérisée par le fait que** l'antenne de rayonnement perturbateur (21) se compose principalement d'un conducteur de couplage long (32) étant posé à une distance peu importante parallèlement au cadre métallique de la fenêtre (42) et dont l'une des extrémités est connectée avec le cadre de la vitre contiguë à cette extrémité à l'aide d'une capacité (40) et dont l'autre extrémité est connectée avec l'électrode de commande (44) d'un élément contrôlable tripolaire à grand résistance sur l'entrée (43) et étant également **caractérisée par le fait que** l'électrode de source (45) de l'élément (43) est connecté à haute fréquence avec le cadre de la vitre contiguë étant conductible (42) et que les dimensions de la boucle ainsi créée et la capacité (40) sont choisies de sorte que le niveau de rayonnement de perturbation (13) résultant du rayonnement de perturbation (11) est le plus représentatif possible des signaux de réception causant des perturbations dans le récepteur (2).

17. Installation de réception selon la revendication 1 **caractérisée par le fait que** l'élément de couplage (3) pour le découplage de signaux de perturbation est réalisé soit comme couplage inductif direct sur l'un des conducteurs électriques conduisant le courant perturbateur (34), soit comme couplage capacitif sur l'un des conducteurs électriques conduisant le courant perturbateur (35) du véhicule mobile (20) soit avec superposition d'un couplage inductif et d'un couplage électrique.

18. Installation de réception selon la revendication 1 **caractérisée par le fait qu'**il existe plusieurs éléments de couplage (3) pour le couplage de perturbations résultant de différentes sources de perturbation, que les perturbations sont amenées à un circuit de matrice (31) pour la superposition pondérée des rayonnements de perturbation propagés par les différentes sources de perturbation (11) et que le signal de sortie du circuit de matrice (31) est transmis au circuit d'évaluation (4)

19. Installation de réception selon la revendication 1 **caractérisée par le fait que** le niveau de signal dans le récepteur (2) est transmis à un indicateur de niveau (38) pour être évalué dans un circuit d'évaluation du niveau (39) pour connaître la durée et/ou la capacité de suppression et que, par le réglage du niveau de référence (9) et/ou du circuit logique (10), une durée et/ou capacité de suppression adéquate(s) est/sont réglée(s).
